## Europäisches Patentamt
## European Patent Office
## Office européen des brevets

(19)

(11) Numéro de publication: **0 121 459**
**B1**

(12) # FASCICULE DE BREVET EUROPEEN

(45) Date de publication du fascicule du brevet:
**01.03.89**

(51) Int. Cl.⁴: **C 03 C 17/245,** C 04 B 41/85, C 23 C 16/40

(21) Numéro de dépôt: **84400451.5**

(22) Date de dépôt: **07.03.84**

(54) Dépôt d'une couche d'oxyde d'étain sur un substrat à partir de composés d'étain à l'état gazeux.

(30) Priorité: **07.03.83 JP 37136/83**

(43) Date de publication de la demande:
**10.10.84 Bulletin 84/41**

(45) Mention de la délivrance du brevet:
**01.03.89 Bulletin 89/9**

(84) Etats contractants désignés:
**AT BE CH DE FR GB IT LI LU NL SE**

(56) Documents cités:
**EP-A- 0 027 403**
**FR-A- 2 323 649**
**US-A- 4 130 673**
**US-A- 4 293 594**

**Le dossier contient des informations techniques présentées postérieurement au dépôt de la demande et ne figurant pas dans le présent fascicule.**

(73) Titulaire: **SAINT-GOBAIN VITRAGE, Les Miroirs 18, avenue d'Alsace, F-92400 Courbevoie (FR)**

(72) Inventeur: **Kato, Yukihiro, 2-1-403 Nigawa-cho 2-chome, Nishinomiya-shi Hyogo-ken (JP)**
Inventeur: **Kawahara, Hideo, 8-3-205 Minami Sakurazuka 2-chome, Toyonaka-shi Osaka-Fu (JP)**
Inventeur: **Hyodo, Masato, 21 Nakano Higashi 3-chome, Itami-shi Hyogo-ken (JP)**

(74) Mandataire: **Leconte, Jean-Gérard et al, Saint-Gobain Recherche 39, Quai Lucien Lefranc, F-93304 Aubervilliers Cedex (FR)**

## Description

La présente invention concerne le dépôt d'une couche d'oxyde d'étain sur la surface d'un substrat en verre, céramique, métal ou autres matières.

Plus précisément, elle porte sur une méthode de dépôt d'une couche d'oxyde d'étain par la mise en contact de composés organiques d'étain à l'état gazeux avec la surface d'un substrat en verre, céramique, métal ou autres matières, chauffé à une haute température. En général, la couche d'oxyde d'étain étant très dure, elle est utilisée largement pour éviter la détérioration de la surface des vaisselles, bouteilles, etc. Par ailleurs, il y a de nombreuses applications profitant de la conduction électrique de la couche d'oxyde d'étain; par exemple, les verres revêtus d'une telle couche sont largement employés comme conducteurs transparents tels qu'électrodes pour des cristaux liquides, verres anti-buée, etc. Egalement, des plaquettes céramiques fines revêtues d'une couche d'oxyde d'étain sont extrêmement employées en tant que pièces électriques. En plus, en profitant du caractère réflecteur des rayons infra-rouges de la couche d'oxyde d'étain, des verres ou tubes métalliques revêtus d'une couche d'oxyde d'étain sont utilisés comme couvercles ou tubes de capteurs solaires.

Il existe plusieurs méthodes pour déposer une couche d'oxyde d'étain sur la surface d'un substrat en verre, céramiqué, métal ou autres matières. Comme méthode appropriée pour la fabrication en série, on utilise depuis longtemps la méthode qui consiste à pulvériser une solution de tétrachlorure d'étain sur la surface du substrat maintenu à haute température. Depuis quelques années, on utilise également la méthode dite «CVD» (Chemical Vapor deposition), qui consiste à mettre en contact la vapeur obtenue par chauffage et vaporisation de tétrachlorure d'étain, de diméthyl dichlorure d'étain, de monobutyl trichlorure d'étain (US 4 293 594) avec un substrat en verre, céramique, métal ou autres matières chauffé à haute température.

Toutefois, les couches d'oxyde d'étain ainsi obtenues présentent par endroit des zones troubles d'aspect légèrement laiteux. Ce défaut est d'autant plus marqué que la couche d'oxyde d'étain est plus épaisse. Ces couches ayant ces défauts ne peuvent pas être utilisées pour constituer des électrodes de verre pour afficheurs de grandes tailles, les couches dans ce cas devant être parfaitement transparentes ainsi qu'uniformes et homogènes, devant également posséder de bonnes performances électriques et de faibles résistances électriques.

Pour atténuer ces défauts, on a essayé de déposer une vapeur constituée par un mélange de tétraméthyl étain $(CH_3)_4Sn$ et de bromotrifluorométhane $(CF_3Br)$ sur des substrats en verre préalablement revêtus d'une sous couche d'oxyde de silicium. En l'absence de cette sous couche, le revêtement est pratiquement inexistant, et en plus le tétraméthyl étain est très toxique, ce qui rend son emploi non approprié au CVD.

On a par ailleurs proposé d'employer le dibutyl-diacétate d'étain $(C_4H_9)_2Sn(CH_3COO)_2$ moins toxique que le tétraméthyl étain, en mélange avec du bromotrifluorométhane $(CF_3Br)$, mais le dépôt obtenu n'a pas une bonne résistance mécanique, ni une bonne conduction électrique.

On a également proposé dans EP 27 403 d'employer des composés d'étain en mélange avec des composés organo-fluorés du type $Cn\ Hm\ Cl_xF_y$ et parmi eux préférentiellement $CCl_2F_2$, $CHClF_2$, $CH_3–CH_2$, mais les couches obtenues n'ont pas des performances électriques suffisantes pour réaliser de l'affichage.

La présente invention vise à fabriquer des couches de revêtement de substrats à partir de composés moins toxiques que le tétraméthyl étain, ces couches ayant une grande homogénéité, de bonnes propriétés électriques, en particulier une faible résistance électrique, et ne faisant pas apparaître de trouble.

Pour cela elle propose d'employer comme composé organique le monobutyl trichlorure d'étain, $C_4H_9SnCl_3$, composé qui ne se dissocie pas facilement sous l'action de la chaleur et qui permet d'obtenir rapidement une couche d'oxyde d'étain d'excellente qualité, ce composé à l'état gazeux étant préalablement mélangé avec un autre composé à l'état gazeux, à savoir $XCHF_2$ dans lequel X est un radical hydrocarboné à base de carbone et d'hydrogène, du chlore ou du fluor.

Grâce à l'association de ces deux composés, on peut obtenir des couches de l'épaisseur désirée, on peut réduire et pratiquement supprimer les zones troubles, on peut atteindre des vitesses de dépôt élevées. En outre, les couches ainsi obtenues ont d'excellentes caractéristiques électriques.

Ces couches peuvent être d'excellente qualité même sans sous couche de silice.

Pour obtenir les meilleures caractéristiques électriques, il est souhaitable que la vitesse de projection soit inférieure à 15 m/s et de préférence comprise entre 0,2 et 8 m/s.

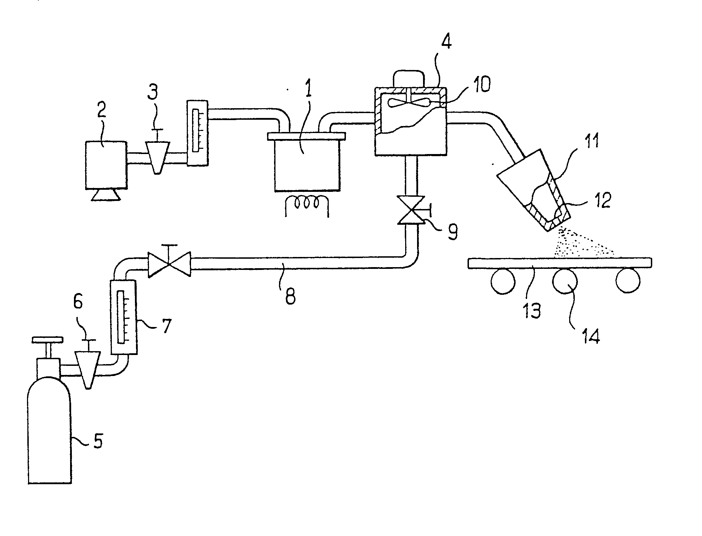

L'invention sera maintenant décrite plus en détail en référence à la figure jointe qui représente un schéma du dispositif permettant de vaporiser le composé d'étain et de le mettre en contact avec le substrat chauffé.

De la vapeur d'un composé d'étain est produite dans un vaporisateur 1. Ce vaporisateur est traversé par un courant de gaz vecteur fourni par un compresseur 2 associé à un détendeur 3. Ce gaz vecteur entraîne la vapeur de composé d'étain lors de sa traversée du vaporisateur 1, jusqu'à un mélangeur 4. Ce même mélangeur 4 reçoit par ailleurs un autre composé gazeux destiné à doper le composé d'étain. Ce dopant emmagasiné dans une bouteille 5 est détendu par un détendeur 6, dosé par un débimètre 7 puis acheminé par un tuyau 8 muni d'une vanne 9 jusqu'au mélangeur 4. Dans ce mélangeur 4, la vapeur de composé d'étain et le dopant gazeux sont intimement mélangés grâce à un agitateur 10. A la sortie du mélangeur 4, le mélange ainsi réalisé est acheminé jusqu'à une buse de projection 11 munie d'une fente de distribution 12 pour être projeté sur un substrat 13 par exemple en verre, notamment des feuilles de verre ou un ruban continu de verre, entraîné en défilement sous la buse 11 grâce à des rouleaux 14.

Comme composé d'étain on emploie le monobutyl trichlorure d'étain $C_4H_9SnCl_3$. Après l'avoir introduit dans l'évaporateur 1, on l'a chauffé à une température comprise entre 40 et 90°C pour produire la vapeur. On a choisi comme gaz porteur de l'azote et on l'a délivré à raison de 30 l/min avec une pression de 1 kg/cm². Comme dopant, on a utilisé du chlorodifluorométhane $Cl–CHF_2$, du trifluorométhane $F–CHF_2$ ou du 1-1 difluoroéthane $CH_3–CHF_2$.

Le mélange gazeux obtenu avec l'un de ces dopants et le monobutyltrichlorure d'étain a été projeté sur des substrats en verre sodocalcique de 30 mm × 300 mm et de 3 mm d'épaisseur, soit nus, soit revêtus d'une sous-couche de silice $SiO_2$ de 1000 Angstroëms d'épaisseur, ces substrats étant dans les deux cas chauffés à 520°C et entraînés à une vitesse par rapport à la buse 11 de 20 cm/min.

On a choisi pour chaque dopant des proportions telles que la valeur de la résistance électrique des couches d'oxyde d'étain obtenues soit la plus faible possible. De la même façon on a ajusté la distance entre la buse de projection et le substrat de façon que la résistance électrique des couches obtenues soit la plus faible.

La vitesse de projection du mélange de gaz à la sortie de la buse 11 au travers de la fente de distribution 12 a été fixée à 0,8 m/s.

C'est ainsi qu'on a déposé des couches d'oxyde d'étain d'une épaisseur de 2000 Angstroëm (200 nm) sur la surface des échantillons de verre nu et des échantillons de verre revêtus préalablement d'une sous-couche de silice en projetant des mélanges de monobutyl trichlorure d'étain et successivement de chacun des trois dopants répondant à la formule générale $XCHF_2$.

On a mesuré la résistance électrique de chacune des couches obtenues; les valeurs de résistivité obtenues ont été portées dans le tableau disposé en fin de description.

Ensuite pour permettre des comparaisons on a réalisé d'autres couches dans les mêmes conditions, sur des substrats équivalents avec le même composé d'étain, mais en remplaçant le dopant $XCHF_2$ par d'autres dopants à savoir le bromotrifluorométhane ($CF_3Br$), le dichlorofluorométhane ($Cl–CClF_2$), le chlorotrifluorométhane ($F–CClF_2$) et le monochloro-1-difluoro-1-éthane ($CH_3CClF_2$). Les resistivités électriques des couches ont également été portées dans le tableau disposé en fin de description.

Egalement pour permettre des comparaisons, on a réalisé d'autres couches d'oxyde d'étain sur des substrats du même type que précédemment, mais en utilisant comme composés d'étain, successivement le tétrabutyl étain ($C_4H_9)_4Sn$, le dibutyl diacétate d'étain et le tétraméthyl étain ($CH_3)_4Sn$ et dans les trois cas le bromotrifluorométhane en tant que dopant. Dans ces dernières opérations, la seule différence réside dans le fait que le tétraméthyl étain était fourni au mélangeur 4 directement à partir d'une bouteille. Comme dans les cas précédents, on a mesuré la résistance électrique des couches obtenues et on a reporté les résultats dans le tableau disposé en fin de description.

Ainsi qu'il ressort clairement du tableau, les couches selon l'invention présentent de meilleures caractéristiques que les autres. Leur résistivité en ohm.cm arrivant à être inférieure à $8.10^{-4}$ et étant dans tous les cas inférieure à $10^{-3}$.

En outre, même en employant le monobutyl trichlorure d'étain comme composé d'étain, mais en utilisant des dopants autres que ceux répondant à la formule générale $XCHF_2$, c'est-à-dire dans les expériences références 4, 5, 6 et 7 dans le tableau, les performances électriques sont moins bonnes que lorsqu'on emploie un dopant du type $XCHF_2$.

On constate également que selon l'expérience 10, alors que la couche d'étain obtenue sur le substrat préalablement revêtu de silice a des performances acceptables, la couche sur le substrat nu est pratiquement impossible à obtenir.

TABLEAU

| | | matières premières de départ | | résistivité électrique (ohm.cm) | |
| | ref. | composé d'étain | dopant (fluorure) | substrat: verre sodocalcique | substrat: verre sodocalcique revêtu de SiO₂ |
| --- | --- | --- | --- | --- | --- |
| INVENTION | 1 | Monobutyl trichlorure d'étain | chlorodifluorométhane | $7.8 \times 10^{-4}$ | $4.7 \times 10^{-4}$ |
| | 2 | idem | trifluorométhane | $1.1 \times 10^{-3}$ | $9.0 \times 10^{-4}$ |
| | 3 | idem | 1.1-difluoroéthane | $7.4 \times 10^{-4}$ | $4.7 \times 10^{-4}$ |

| | ref. | matières premières de départ<br>composé d'étain | dopant (fluorure) | résistivité électrique (ohm.cm)<br>substrat:<br>verre sodocalcique | substrat:<br>verre sodo-<br>calcique<br>revêtu de $SiO_2$ |
|---|---|---|---|---|---|
| EXEMPLES COMPARATIFS | 4 | Monobutyl trichlorure d'étain | Bromotrifluorométhane | $2.7 \times 10^{-3}$ | $2.6 \times 10^{-3}$ |
| | 5 | idem | Dichlorodifluorométhane | $2.9 \times 10^{-3}$ | $2.8 \times 10^{-3}$ |
| | 6 | idem | Chlorotrifluorométhane | $3.1 \times 10^{-3}$ | $2.9 \times 10^{-3}$ |
| | 7 | idem | Chloro-1 difluoro-1 étane | $2.6 \times 10^{-3}$ | $2.5 \times 10^{-3}$ |
| | 8 | Tetrabutyl d'étain | Bromotrifluorométhane | la couche d'oxyde de Sn est presque nulle | $5.9 \times 10^{-3}$ |
| | 9 | Dibutyl diacétate d'étain | Bromotrifluorométhane | $2.7 \times 10^{-3}$ | $2.7 \times 10^{-3}$ |
| | 10 | Tetraméthyl d'étain | Bromotrifluorométhane | la couche d'oxyde de Sn est presque nulle | $1.1 \times 10^{-3}$ |

## Revendications

1. Procédé de dépôt d'une couche d'oxyde d'étain sur un substrat, notamment en verre, consistant à mettre une vapeur contenant des composés d'étain en contact avec le substrat porté à haute température caractérisé en ce que la vapeur contient du monobutyl trichlorure d'étain en tant que composé d'étain et un dopant répondant à la formule générale $XCHF_2$ où X est un groupement à base de carbone et d'hydrogène, du chlorure ou du fluor.

2. Procédé selon la revendication 1, caractérisé en ce que le dopant appartient au groupe des produits suivants: chlorodifluorométhane, trifluorométhane, 1.1 difluoroéthane.

3. Procédé selon l'une des revendications précédentes caractérisé en ce que la vapeur est projetée sur le substrat avec une vitesse inférieure à 15 m/s et de préférence comprise entre 0,2 et 8 m/s.

## Claims

1. Method of depositing a layer of stannic oxide on a substrate, notably of glass, consisting of bringing a vapour containing tin compounds into contact with the substrate heated to high temperature, characterized in that the vapour contains monobutyl tin trichloride as tin compound and a dopant complying with the general formula $XCHF_2$, where X is a group based upon carbon and hydrogen, or is chlorine or fluorine.

2. Method according to Claim 1, characterized in that the dopant belongs to the group of the following products: chlorodifluoromethane, trifluoromethane, 1.1 difluoroethane.

3. Method according to one of the preceding Claims, characterized in that the vapour is projected onto the substrate at a velocity less than 15 m/s and preferably lying between 0.2 and 8 m/s.

## Patentansprüche

1. Verfahren zum Aufbringen einer Zinnoxid-Schicht auf ein Substrat, insbesondere Glas, bei welchem Zinnverbindungen enthaltender Dampf in Kontakt mit dem auf hohe Temperatur erwärmten Substrat gebracht wird, dadurch gekennzeichnet, daß der Dampf der Zinnverbindung Monobutyltrichlorid von Zinn sowie ein Dotierungsmittel mit der allgemeinen Formel XCHF2 enthält, bei dem X aus der Gruppe von Kohlenstoff und Wasserstoff, von Chlor oder Fluor gebildet ist.

2. Verfahren nach Anspruch 1, dadurch gekennzeichnet, daß das Dotierungsmittel zur Gruppe folgender Stoffe gehört, nämlich Chlordifluormethan, Trifluormethan, 1.1 Difluoräthan.

3. Verfahren nach einem der vorhergehenden Ansprüche, dadurch gekennzeichnet, daß der Dampf auf das Substrat mit einer Geschwindigkeit kleiner als 15 m/s und zwar vorzugsweise zwischen 0,2 und 8 m/s aufgebracht wird.